(19) Europäisches Patentamt / European Patent Office / Office européen des brevets

(11) **EP 4 579 731 A1**

(12) **EUROPEAN PATENT APPLICATION**
published in accordance with Art. 153(4) EPC

(43) Date of publication:
**02.07.2025 Bulletin 2025/27**

(21) Application number: **23857071.7**

(22) Date of filing: **24.07.2023**

(51) International Patent Classification (IPC):
**H01L 23/36** (2006.01)     **H01L 23/373** (2006.01)

(52) Cooperative Patent Classification (CPC):
**H01L 23/36; H01L 23/373**

(86) International application number:
**PCT/JP2023/026970**

(87) International publication number:
**WO 2024/042955 (29.02.2024 Gazette 2024/09)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **26.08.2022 JP 2022134628**

(71) Applicant: **Denka Company Limited
Tokyo 103-8338 (JP)**

(72) Inventors:
• **IGARASHI, Kazuyuki
Tokyo 103-8338 (JP)**
• **IWASAKI, Takayuki
Tokyo 103-8338 (JP)**

(74) Representative: **Hoffmann Eitle
Patent- und Rechtsanwälte PartmbB
Arabellastraße 30
81925 München (DE)**

(54) **HEAT DISSIPATION GREASE**

(57) Provided is a thermal grease including: matrix component; and filler component, in which the matrix component comprises a silicone A and a surfactant B, the filler component comprises: alumina D1; and magnesium oxide D2, and/or aluminum nitride D3, a content of the surfactant B may be 15% by mass or more based on a total amount of the matrix component, and a total content of the magnesium oxide D2 and the aluminum nitride D3 is 10% to 60% by mass based on a total amount of the filler component.

EP 4 579 731 A1

## Description

Technical Field

The present invention relates to a thermal grease.

Background Art

Along with the miniaturization and increase in output of heat-generating electronic components such as a central processing unit (CPU) of a personal computer, the heat quantity per unit area generated from these electronic components has become very large. The heat quantity thereof reaches about 20 times that of the heat quantity of an iron. In order to prevent heat-generating electronic components from breaking down over a long period of time, cooling of the heat-generating electronic components is required.

A metal heat sink or housing is used for cooling, and a thermal conductive material is used for efficiently transferring heat from a heat-generating electronic component to a cooling unit such as a heat sink or a housing. In a case where the heat-generating electronic component and the heat sink or the like are brought into contact with each other in a state where there is no thermal conductive material, air exists microscopically at an interface therebetween, which hinders thermal conduction. Therefore, heat is efficiently transferred by causing a thermal conductive material to be present between the heat-generating electronic component and the heat sink or the like instead of air existing at the interface.

Examples of the thermal conductive material include a thermally conductive pad or a thermally conductive sheet formed by filling a thermosetting resin with a thermally conductive filler and forming the thermosetting resin into a sheet shape, a thermal grease which can be applied or thinned by filling a flowable resin with a thermally conductive filler, and a phase change type thermal conductive material softened or fluidized at an operating temperature of a heat generating electronic component.

A sheet-like heat dissipation material is easy to handle and excellent in long-term shape maintainability, but has high contact thermal resistance and is inferior to a grease-like heat dissipation material in terms of automatic mounting. Therefore, in recent years, a thermal grease has increasingly been used with a thickness that was previously used in a sheet.

Such a thermal grease generally includes an inorganic filler surface-treated with a silane coupling agent or the like in a resin. As a surface treatment agent other than a silane coupling agent, for example, a copolymer containing a polybutadiene constituent unit, a constituent unit having a hydrolyzable silyl group, and a constituent unit having a polysiloxane skeleton is known (see, for example, Patent Literature 1).

Citation List

Patent Literature

Patent Literature 1: JP 2018-062552 A

Summary of Invention

Technical Problem

However, the conventional thermal grease has a problem that hardness is likely to change due to long-term use or the like, and heat dissipation is likely to deteriorate. For this reason, there is a demand for a thermal grease that is less likely to change in hardness while achieving low viscosity and high thermal conductivity of the thermal grease.

The present invention has been made in view of the above problems, and an object of the present invention is to provide a thermal grease that is less likely to change in hardness while achieving low viscosity and high thermal conductivity.

Solution to Problem

That is, the present invention is as follows.

[1] A thermal grease including:

matrix component; and filler component,
in which the matrix component comprises a silicone A and a surfactant B,

the filler component comprises:

  alumina D1; and
  magnesium oxide D2, and/or aluminum nitride D3,

  a content of the surfactant B may be 15% by mass or more based on a total amount of the matrix component, and
  a total content of the magnesium oxide D2 and the aluminum nitride D3 is 10% to 60% by mass based on a total amount of the filler component.

[2] The thermal grease according to [1],
in which a content of the filler component is 60% to 95% by volume based on a total amount of the thermal grease.
[3] The thermal grease according to [1] or [2],

  in which an average particle diameter of the magnesium oxide D2 is 25 to 300 $\mu$m, and
  an average particle diameter of the aluminum nitride D3 is 25 to 300 $\mu$m.

[4] The thermal grease according to any one of [1] to [3],
in which the alumina D1 further comprises alumina D11 having an average particle diameter of 55 $\mu$m or more.
[5] The thermal grease according to any one of [1] to [4],
in which the silicone A comprises:

  a low molecular silicone A1 having a weight average molecular weight of 500 or more and 100,000 or less; and
  a high molecular silicone A2 having a weight average molecular weight of 150,000 or more and 1,000,000 or less.

[6] The thermal grease according to any one of [1] to [5],
in which a content of the low molecular silicone A1 is 50% to 80% by mass based on a total amount of the matrix component.
[7] The thermal grease according to any one of [1] to [6],
in which a content of the high molecular silicone A2 is 3.0% to 25% by mass based on a total amount of the matrix component.
[8] The thermal grease according to any one of [1] to [7],
in which a content of the surfactant B is 15% to 55% by mass based on a total amount of the matrix component.
[9] The thermal grease according to any one of [1] to [8],
in which the surfactant B comprises:

  a surfactant B1 having a silicone (meth)acrylic monomer unit $\gamma 1$ having a weight average molecular weight of 1,000 or more and less than 8,000; and/or
  a surfactant B2 having a silicone (meth)acrylic monomer unit $\gamma 2$ having a weight average molecular weight of 8,000 or more and 50,000 or less.

[10] The thermal grease according to any one of [1] to [9],
in which the matrix component further comprises a silane coupling agent C.
[11] The thermal grease according to [10],
in which a content of the silane coupling agent C is 2.0% to 16% by mass based on a total amount of the matrix component.
[12] The thermal grease according to any one of [1] to [11],

  in which the filler component further comprises silica D4, and
  a content of the silica D4 is 0.1% to 10% by mass based on a total amount of the filler component.

Advantageous Effects of Invention

According to the present invention, it is possible to provide a thermal grease that is less likely to change in hardness while achieving low viscosity and high thermal conductivity.

Description of Embodiments

Hereinafter, embodiments of the present invention (hereinafter, referred to as "the present embodiment") will be described in detail, but the present invention is not limited thereto, and various modifications can be made without departing from the gist of the present invention.

## 1. Thermal grease

A thermal grease of the present embodiment comprises: matrix component; and filler component, in which the matrix component comprises a silicone A and a surfactant B, the filler component comprises: alumina D1; and magnesium oxide D2 and/or aluminum nitride D3, a content of the surfactant B may be 15% by mass or more based on a total amount of the matrix component, and a total content of the magnesium oxide D2 and the aluminum nitride D3 is 10% to 60% by mass based on a total amount of the filler component.

The conventional thermal grease has a problem that hardness is likely to change due to long-term use or the like, and heat dissipation is likely to deteriorate. Meanwhile, in the present embodiment, a predetermined amount of the surfactant B, the alumina D1, the magnesium oxide D2, and/or the aluminum nitride D3 is used in combination. As a result, it is possible to achieve a thermal grease that is less likely to change in hardness while achieving low viscosity and high thermal conductivity. Hereinafter, the composition of the thermal grease will be described in detail.

### 1.1. Matrix component

The matrix component comprises the silicone A and the surfactant B, and may further comprises a silane coupling agent C or the like as necessary.

### 1.1.1. Silicone A

The form of the silicone A is not particularly limited, and examples thereof include non-crosslinked silicones such as linear silicones, branched silicones, and cyclic silicones; and crosslinked silicones three-dimensionally crosslinked in a molecule. Among them, non-crosslinked silicones are preferable, and linear silicones are more preferable. When using such a silicone A, the viscosity tends to decrease, and a change in hardness tends to be further suppressed.

In general, silicones can be represented by a monofunctional unit ($R^1SiO_{1/2}$), a bifunctional unit ($R^2SiO_{2/2}$), a trifunctional unit ($R^3SiO_{3/2}$), and a tetrafunctional unit ($SiO_{4/2}$). For example, linear silicones can be expressed as having a monofunctional unit ($R^1SiO_{1/2}$) constituting a terminal and a bifunctional unit ($R^2SiO_{2/2}$) constituting a main chain ($n3$, $n4 = 0$ in the following formula), and cyclic silicones can be expressed as having a bifunctional unit ($RSiO_{2/2}$) constituting a ring ($n1$, $n3$, $n4 = 0$ in the following formula). In addition, branched silicones or three-dimensionally crosslinked silicones can be expressed as having a trifunctional unit ($R^3SiO_{3/2}$) and/or a tetrafunctional unit ($SiO_{4/2}$) constituting a branch point, and can further be expressed as having a monofunctional unit ($R^1SiO_{1/2}$) constituting a terminal of a branched chain and a bifunctional unit ($R^2SiO_{2/2}$) constituting a branched chain.

The composition formula using such units can be expressed as follows. In the following formula, $n1$ to $n4$ represent compositional proportions of units respectively, and can be represented by a ratio such that a total of $n1$ to $n4$ is 1. Whether or not these units are contained can be measured by a known method such as Si-NMR. $R^1$ to $R^4$ can each independently represent any group.

$$(R^1SiO_{1/2})_{n1}(R^2SiO_{2/2})_{n2}(R^3SiO_{3/2})_{n3}(SiO_{4/2})_{n4}$$

The silicone A is not particularly limited, and examples thereof include non-curable silicones and curable silicones. The non-curable silicone resin is not particularly limited as long as it does not have a functional group contributing to curing that the curable silicone resin has or it is not used in combination with a catalyst. Also, the curable silicone is not particularly limited, and examples thereof include those in which two kinds of silicones having functional groups that react with each other are used in combination. Such a curable silicone is not particularly limited, and examples thereof include addition curable silicones, condensation curable silicones, and peroxide curable silicones.

Among them, the silicone A is preferably a non-curable silicone. When using such a silicone A, a one-component thermal grease can be obtained, and handleability tends to be further improved.

Also, the silicone A is not particularly limited, and examples thereof include dimethyl silicone, diphenyl silicone, and methylphenyl silicone. In addition, an organic group may be introduced into a side chain and/or a terminal of these silicones. Such a silicone is not particularly limited, and examples thereof include non-reactive silicones such as long-chain alkyl-modified silicone, polyether-modified silicone, aralkyl-modified silicone, fatty acid ester-modified silicone, and fatty acid amide-modified silicone; and reactive silicones such as amine-modified silicone, epoxy-modified silicone, mercapto-modified silicone, carboxyl-modified silicone, carbinol-modified silicone, and hydrogen-modified silicone.

Among them, dimethyl silicone, diphenyl silicone, methylphenyl silicone, and non-reactive silicones are preferable, and dimethyl silicone is more preferable. When using such a silicone A, the viscosity tends to decrease, and a change in hardness tends to be further suppressed.

A content of the silicone A may be preferably 60% by mass or more, 65% by mass or more, 70% by mass or more, or 75% by mass or more based on a total amount of the matrix component. Also, the content of the silicone A may be preferably 90% by mass or less, 85% by mass or less, or 80% by mass or less based on the total amount of the matrix component. When the content of the silicone A based on the total amount of the matrix component is within the above range, the viscosity tends to decrease, and a change in hardness tends to be further suppressed.

The silicone A may contain at least one of a low molecular silicone A1 having a weight average molecular weight of 500 or more and 100,000 or less and a high molecular silicone A2 having a weight average molecular weight of 150,000 or more and 1,000,000 or less, or may contain both thereof. Among them, it is preferable to include both the low molecular silicone A1 and the high molecular silicone A2. When using the low molecular silicone A1 and the high molecular silicone A2, the viscosity tends to decrease, and a change in hardness tends to be further suppressed.

1.1.1.1. Low molecular silicone A1

The weight average molecular weight of the low molecular silicone A1 may be 500 or more, and preferably 1,000 or more, 1,500 or more, 2,000 or more, or 2,500 or more. Also, the weight average molecular weight of the low molecular silicone A1 may be 100,000 or less, and preferably 50,000 or less, 25,000 or less, 15,000 or less, 10,000 or less, or 7,500 or less. When using such a low molecular silicone A1, the viscosity tends to decrease, and a change in hardness tends to be further suppressed.

The viscosity of the low molecular silicone A1 at 25°C may be preferably 1.0 mPa·s or higher, 5.0 mPa·s or higher, 10 mPa·s or higher, 20 mPa·s or higher, or 30 mPa·s or higher. Also, the viscosity of the low molecular silicone A1 at 25°C may be preferably 5,000 mPa·s or lower, 4,000 mPa·s or lower, 3,000 mPa·s or lower, 2,000 mPa·s or lower, or 1,000 mPa·s or lower. When the viscosity of the low molecular silicone A1 is within the above range, the viscosity tends to decrease, and a change in hardness tends to be further suppressed.

The content of the low molecular silicone A1 may be preferably 50% by mass or more, 55% by mass or more, 60% by mass or more, or 65% by mass or more based on the total amount of the matrix component. When the content of the low molecular silicone A1 based on the total amount of the matrix component is 50% by mass or more, the viscosity tends to decrease.

The content of the low molecular silicone A1 may be preferably 80% by mass or less, 75% by mass or less, 70% by mass or less, or 65% by mass or less based on the total amount of the matrix component. When the content of the low molecular silicone A1 based on the total amount of the matrix component is 80% by mass or less, a change in hardness tends to be further suppressed.

**1.1.1.2.** High molecular silicone A2

The weight average molecular weight of the high molecular silicone A2 may be 150,000 or more, and preferably 200,000 or more, 250,000 or more, 300,000 or more, or 350,000 or more. The weight average molecular weight of the high molecular silicone A2 may be 1,000,000 or less, and preferably 900,000 or less, 800,000 or less, 700,000 or less, or 600,000 or less. When using such a high molecular silicone A2, the viscosity tends to decrease, and a change in hardness tends to be further suppressed.

The viscosity of the high molecular silicone A2 at 25°C may be preferably 1,000 Pa·s or higher, 2,500 Pa·s or higher, 5,000 Pa·s or higher, 7,500 Pa·s or higher, or 10,000 Pa·s or higher. Also, the viscosity of the high molecular silicone A2 at 25°C may be preferably 50,000 mPa·s or lower, 40,000 mPa·s or lower, 30,000 mPa·s or lower, 20,000 mPa·s or lower, or 15,000 mPa·s or lower. When the viscosity of the high molecular silicone A2 is within the above range, the viscosity tends to decrease, and a change in hardness tends to be further suppressed.

The content of the high molecular silicone A2 may be preferably 3.0% by mass or more, 5.0% by mass or more, 7.0% by mass or more, 9.0% by mass or more, or 12% by mass or more based on the total amount of the matrix component. When the content of the high molecular silicone A2 based on the total amount of the matrix component is 3.0% by mass or more, a change in hardness tends to be further suppressed.

The content of the high molecular silicone A2 may be preferably 25% by mass or less, 20% by mass or less, 15% by mass or less, or 12.5% by mass or less based on the total amount of the matrix component. When the content of the high molecular silicone A2 based on the total amount of the matrix component is 25% by mass or less, the viscosity tends to decrease.

A ratio (A1/A2) of the content of the low molecular silicone A1 to the content of the high molecular silicone A2 may be preferably 1.5 or more, 2.0 or more, 2.5 or more, 3.0 or more, 3.5 or more, or 4.0 or more. In addition, the ratio (A1/A2) of the content of the low molecular silicone A1 to the content of the high molecular silicone A2 may be preferably 10 or less, 9.0 or less, 8.0 or less, 7.0 or less, or 6.0 or less. When the ratio (A1/A2) is within the above range, the viscosity tends to decrease, and a change in hardness tends to be further suppressed.

1.1.2. Surfactant B

The surfactant B is not particularly limited. Among them, as the surfactant B, a polymer having a silicone (meth) acrylic monomer unit $\gamma$ is preferable, and a copolymer having a (meth)acrylic monomer unit $\alpha$ having an anionic group, a (meth)acrylic monomer unit $\beta$ having a cationic group, and a silicone (meth)acrylic monomer unit $\gamma$ is more preferable. When using such a surfactant B, dispersibility of the filler component can be maintained. Therefore, from the viewpoint of thermal conductivity, even if filling with the filler component is highly performed, the viscosity tends to further decrease, and a change in hardness tends to be further suppressed.

A content of the surfactant B may be 15% by weight or more, preferably 17.5% by weight or more, 20% by weight or more, 22.5% by weight or more, 25% by weight or more, 27.5% by weight or more, or 30% by weight or more based on the total amount of the matrix component. The content of the surfactant B may be preferably 55% by weight or less, 50% by weight or less, 45% by weight or less, 40% by weight or less, 35% by weight or less, or 30% by weight or less based on the total amount of the matrix component. When the content of the surfactant B based on the total amount of the matrix component is within the above range, the viscosity tends to further decrease, and a change in hardness tends to be further suppressed.

The content of the surfactant B may be preferably 10 parts by weight or more, 15 parts by weight or more, 20 parts by weight or more, 25 parts by weight or more, 30 parts by weight or more, 35 parts by weight or more, 40 parts by weight or more, 45 parts by weight or more, or 50 parts by weight or more based on 100 parts by weight of the content of the silicone A. Also, the content of the surfactant B may be preferably 75 parts by weight or less, 70 parts by weight or less, 65 parts by weight or less, or 60 parts by weight or less based on 100 parts by weight of the content of the silicone A. When the content of the surfactant B based on the silicone A is within the above range, the viscosity tends to further decrease, and a change in hardness tends to be further suppressed.

Hereinafter, the surfactant B will be described in more detail. In the present embodiment, the "monomer" refers to a monomer having a polymerizable unsaturated bond before polymerization, and the "monomer unit" refers to a repeating unit that forms a part of the surfactant B after polymerization, and is derived from a predetermined monomer. In addition, the (meth)acrylic includes acrylic and methacrylic, and the (meth)acrylic monomer includes (meth)acrylate and (meth) acrylamide. Further, hereinafter, the "(meth)acrylic monomer unit $\alpha$" and the like are also simply referred to as a "unit $\alpha$" and the like.

1.1.2.1. (Meth)acrylic monomer unit $\alpha$

The (meth)acrylic monomer unit $\alpha$ is a repeating unit having an anionic group. The anionic group is not particularly limited, and examples thereof include a carboxy group, a phosphate group, a phenolic hydroxy group, and a sulfonic acid group. Among them, one or more selected from the group consisting of a carboxy group, a phosphate group, and a phenolic hydroxy group are preferable. When having such a group, the dispersibility of the filler component tends to be further improved.

Also, it is preferable that the unit $\alpha$ further have an electron withdrawing group bonded to an anionic group. Such an electron withdrawing group is not particularly limited as long as it has an action of stabilizing the anion of an anionic group. For example, an acrylic monomer containing an electron withdrawing substituent such as a halogen element at a carbon atom at an $\alpha$-position of a carboxy group may be used. When having such a group, the dispersibility of the filler component tends to be further improved.

It is preferable that the unit $\alpha$ have no electron donating group bonded to the anionic group or have a group having low electron-donating property. Such an electron donating group is not particularly limited as long as it has an action of destabilizing the anion of an anionic group. For example, an acrylic monomer not containing a substituent of an electron donating group such as a methyl group at a carbon atom at an $\alpha$-position of a carboxy group may be used. When adopting such a structure, the dispersibility of the filler component tends to be further improved.

Such a (meth)acrylic monomer is not particularly limited, and examples thereof include acrylic acid, methacrylic acid, acid phosphoxypropyl methacrylate, acid phosphoxy polyoxyethylene glycol monomethacrylate, acid phosphoxy polyoxypropylene glycol monomethacrylate, phosphoric acid-modified epoxy acrylate, 2-acryloyloxyethyl acid phosphate, 2-methacryloyloxyethyl acid phosphate, 4-hydroxyphenyl acrylate, 4-hydroxyphenyl methacrylate, 2-methacryloyloxyethyl succinic acid, and 2-acrylamido-2-methylpropanesulfonic acid.

Among them, acrylic acid, 2-methacryloyloxyethyl acid phosphate, 4-hydroxyphenyl methacrylate, and 2-acrylamido-2-methylpropanesulfonic acid are preferable, and acrylic acid is more preferable. When containing a unit derived from such a monomer, the viscosity tends to further decrease, and a change in hardness tends to be further suppressed. The unit $\alpha$ may be used singly or in combination of two or more kinds thereof.

A content of the unit $\alpha$ may be preferably 1.0 mol% or more, 5.0 mol% or more, 10 mol% or more, 20 mol% or more, 30 mol% or more, 40 mol% or more, or 45 mol% or more, based on 100 mol% in total of the unit $\alpha$, the unit $\beta$, and the unit $\gamma$. In addition, the content of the unit $\alpha$ may be preferably 85 mol% or less, 80 mol% or less, 75 mol% or less, or 70 mol% or less, based on 100 mol% in total of the unit $\alpha$, the unit $\beta$, and the unit $\gamma$. When the content of the unit $\alpha$ is within the above range, the viscosity tends to further decrease, and a change in hardness tends to be further suppressed.

A molar ratio of the unit $\alpha$ to the unit $\beta$ may be preferably 0.5 or more, 1.0 or more, 2.5 or more, 5.0 or more, 10 or more, 15 or more, 20 or more, or 25 or more. Also, the molar ratio of the unit $\alpha$ to the unit $\beta$ may be preferably 150 or less, 100 or less, 75 or less, 50 or less, or 40 or less. When the molar ratio of the unit $\alpha$ to the unit $\beta$ is within the above range, the viscosity tends to further decrease, and a change in hardness tends to be further suppressed.

1.1.2.2. (Meth)acrylic monomer unit $\beta$

The (meth)acrylic monomer unit $\beta$ is a repeating unit having a cationic group. The cationic group is not particularly limited, and is preferably, for example, one or more selected from the group consisting of a primary amino group, a secondary amino group, a tertiary amino group, and a quaternary ammonium salt. Among them, a tertiary amino group is more preferable. When having such a group, the dispersibility of the filler component tends to be further improved.

Also, it is preferable that the unit $\beta$ further have an electron donating group bonded to a cationic group. Such an electron donating group is not particularly limited as long as it has an action of stabilizing a cation of a cationic group. For example, an acrylic monomer containing an electron donating substituent such as a methyl group at a carbon atom at an $\alpha$-position of an amino group may be used. When having such a group, the dispersibility of the filler component tends to be further improved.

It is preferable that the unit $\beta$ have no electron withdrawing group bonded to a cationic group or have a group having low electron withdrawing property. Such an electron withdrawing group is not particularly limited as long as it has an action of destabilizing a cation of a cationic group. For example, an acrylic monomer not containing a substituent of an electron withdrawing group such as a carboxyl group at a carbon atom at an $\alpha$-position of an amino group may be used. When adopting such a structure, the dispersibility of the filler component tends to be further improved.

Such a (meth)acrylic monomer is not particularly limited, and examples thereof include 1-aminoethyl acrylate, 1-aminopropyl acrylate, 1-aminoethyl methacrylate, 1-aminopropyl methacrylate, dimethylaminoethyl methacrylate, diethylaminoethyl methacrylate, t-butylaminoethyl (meth)acrylate, dimethylaminoethyl methacrylate quaternary salt, 1,2,2,6,6-pentamethyl-4-piperidyl acrylate, 1,2,2,6,6-pentamethyl-4-piperidyl methacrylate, 2,2,6,6-tetramethyl-4-piperidyl methacrylate, and a dimethylaminoethyl acrylate benzyl chloride quaternary salt.

Among them, 1,2,2,6,6-pentamethyl-4-piperidyl acrylate, 1,2,2,6,6-pentamethyl-4-piperidyl methacrylate, and 1-aminoethyl methacrylate are preferable, and 1,2,2,6,6-pentamethyl-4-piperidyl acrylate and 1,2,2,6,6-pentamethyl-4-piperidyl methacrylate are more preferable. When containing a unit derived from such a monomer, the viscosity tends to further decrease, and a change in hardness tends to be further suppressed. The unit $\beta$ may be used singly or in combination of two or more kinds thereof.

A content of the unit $\beta$ may be preferably 0.05 mol% or more, 0.10 mol% or more, 0.50 mol% or more, 1.00 mol% or more, or 1.50 mol% or more, based on 100 mol% in total of the unit $\alpha$, the unit $\beta$, and the unit $\gamma$. Also, the content of the unit $\beta$ may be preferably 10 mol% or less, 8.0 mol% or less, 10 mol% or less, 6.0 mol% or less, 2.0 mol% or less, or 3.0 mol% or less, based on 100 mol% in total of the unit $\alpha$, the unit $\beta$, and the unit $\gamma$. When the content of the unit $\beta$ is within the above range, the viscosity tends to further decrease, and a change in hardness tends to be further suppressed.

1.1.2.3. (Meth)acrylic monomer unit $\gamma$

The (meth)acrylic monomer unit $\gamma$ is a silicone (meth)acrylic monomer unit, does not contain a cationic group and an anionic group in the molecule, and is a (meth)acrylic monomer having a silicone group.

The (meth)acrylic monomer $\gamma$ preferably has a skeleton having high affinity or compatibility with other matrix component. The (meth)acrylic monomer $\gamma$ has, as such a skeleton, a silicone skeleton such as dimethylsiloxane, methylphenylsiloxane, or diphenylsiloxane. When having such a skeleton, compatibility with other matrix component tends to be further improved, and dispersibility of the filler component in the thermal grease tends to be further improved.

Such a (meth)acrylic monomer is not particularly limited, and examples thereof include a (meth)acrylic monomer having a siloxane skeleton such as $\alpha$-butyl-$\omega$-(3-methacryloxypropyl) polydimethylsiloxane. The unit $\gamma$ may be used singly or in combination of two or more kinds thereof.

A weight average molecular weight of the (meth)acrylic monomer $\gamma$ may be preferably 300 or more, 1,000 or more, 2,000 or more, 3,000 or more, 4,000 or more, 5,000 or more, 6,000 or more, 7,000 or more, or 8,000 or more. The weight average molecular weight of the (meth)acrylic monomer $\gamma$ may be preferably 50,000 or less, 40,000 or less, 30,000 or less, 20,000 or less, 15,000 or less, 12,500 or less, 10,000 or less, or 7,500 or less. Also, when the weight average molecular weight of the (meth)acrylic monomer $\gamma$ is within the above range, the viscosity tends to further decrease, and a change in hardness tends to be further suppressed.

The (meth)acrylic monomer $\gamma$ may include at least one or both of a silicone (meth)acrylic monomer unit $\gamma1$ having a weight average molecular weight of 1,000 or more and less than 8,000 and a silicone (meth)acrylic monomer unit $\gamma2$

having a weight average molecular weight of 8,000 or more and 50,000 or less.

A content of the unit $\gamma$ may be preferably 10 mol% or more, 15 mol% or more, 20 mol% or more, 25 mol% or more, 30 mol% or more, 35 mol% or more, or 40 mol% or more, based on 100 mol% in total of the unit $\alpha$, the unit $\beta$, and the unit $\gamma$. The content of the unit $\gamma$ may be preferably 90 mol% or less, 80 mol% or less, 70 mol% or less, 60 mol% or less, or 50 mol% or less, based on 100 mol% in total of the unit $\alpha$, the unit $\beta$, and the unit $\gamma$. When the content of the unit $\gamma$ is within the above range, the viscosity tends to further decrease, and a change in hardness tends to be further suppressed.

1.1.2.4. Weight average molecular weight

A weight average molecular weight of the surfactant B may be preferably 5,000 or more, 7,500 or more, 10,000 or more, 20,000 or more, 30,000 or more, 40,000 or more, or 50,000 or more. When the weight average molecular weight of the surfactant B is 5,000 or more, dispersibility can be maintained even when the surfactant B is maintained at a high temperature for a long time, and a change in hardness of the thermal grease tends to be further suppressed.

The weight average molecular weight of the surfactant B may be preferably 500,000 or less, 250,000 or less, 150,000 or less, 125,000 or less, 100,000 or less, or 75,000 or less. When the weight average molecular weight of the surfactant B is 500,000 or less, the viscosity of the thermal grease tends to further decrease, and handleability tends to be further improved.

In the present embodiment, each weight average molecular weight can be determined by gel permeation chromatography (GPC).

1.1.2.5. Surfactant B1

The surfactant B may include at least one or both of a surfactant B1 having a silicone (meth)acrylic monomer unit $\gamma 1$ having a weight average molecular weight of 1,000 or more and less than 8,000 and a surfactant B2 having a silicone (meth)acrylic monomer unit $\gamma 2$ having a weight average molecular weight of 8,000 or more and 50,000 or less, preferably includes at least the surfactant B2, and preferably includes both of the surfactant B1 and the surfactant B2. As a result, the viscosity tends to further decrease, and a change in hardness tends to be further suppressed.

The surfactant B1 has a silicone (meth)acrylic monomer unit $\gamma 1$ having a weight average molecular weight of 1,000 or more and less than 8,000, and may further have predetermined unit $\alpha$ and unit $\beta$. When using the surfactant B1, the viscosity tends to further decrease.

The content of the surfactant B1 may be preferably 5% by mass or more, 10% by mass or more, 15% by mass or more, 20% by mass or more, or 25% by mass or more based on the total amount of the matrix component. In addition, the content of the surfactant B1 may be preferably 35% by mass or less, 30% by mass or less, 25% by mass or less, or 20% by mass or less based on the total amount of the matrix component. When the content of the surfactant B1 is within the above range, the viscosity tends to further decrease.

1.1.2.6. Surfactant B2

The surfactant B2 has a silicone (meth)acrylic monomer unit $\gamma 2$ having a weight average molecular weight of 8,000 or more and 50,000 or less, and may further have predetermined unit $\alpha$ and unit $\beta$. A change in hardness tends to be further suppressed.

The content of the surfactant B2 may be preferably 5% by mass or more, 10% by mass or more, 15% by mass or more, 20% by mass or more, or 25% by mass or more based on the total amount of the matrix component. In addition, the content of the surfactant B2 may be preferably 35% by mass or less, 30% by mass or less, 25% by mass or less, or 20% by mass or less based on the total amount of the matrix component. When the content of the surfactant B2 is within the above range, a change in hardness tends to be further suppressed.

1.1.2.7. Viscosity

The viscosity of the surfactant B at 25°C may be preferably 10 mPa·s or higher, 50 mPa·s or higher, 75 mPa·s or higher, or 100 mPa·s or higher. The viscosity of the surfactant B at 25°C may be preferably 2,000 mPa·s or less, 1,500 mPa·s or less, 1,000 mPa·s or less, or 750 mPa·s or less. When the viscosity of the surfactant B is within the above range, a change in hardness tends to be further suppressed.

1.1.2.8. Method for producing surfactant B

A method for producing the surfactant B is not particularly limited, and a known polymerization method of a (meth) acrylic monomer can be used. Examples of the polymerization method include radical polymerization and anionic polymerization. Among them, radical polymerization is preferable.

A thermal polymerization initiator used for radical polymerization is not particularly limited, and examples thereof include azo compounds such as azobisisobutyronitrile; organic peroxides such as benzoyl peroxide, tert-butyl hydroperoxide, and di-tert-butyl peroxide. The photopolymerization initiator used for radical polymerization is not particularly limited, and examples thereof include benzoin derivatives. In addition, a known polymerization initiator used for living radical polymerization such as ATRP or RAFT can also be used.

The polymerization conditions are not particularly limited, and can be appropriately adjusted depending on an initiator to be used or a boiling point of a solvent, and a kind of a monomer.

The order of addition of the monomers is not particularly limited, and for example, from the viewpoint of synthesizing a random copolymer, the monomers may be mixed to initiate the polymerization, or from the viewpoint of synthesizing a block copolymer, the monomers may be sequentially added to a polymerization system.

### 1.1.3. Silane coupling agent C

The matrix component may further include a silane coupling agent C. When containing the silane coupling agent C, the viscosity tends to further decrease, and a change in hardness tends to be further suppressed.

The silane coupling agent C is not particularly limited, and examples thereof include epoxysilanes such as $\gamma$-glycidoxypropyltrimethoxysilane and $\beta$-(3,4-epoxycyclohexyl) ethyltrimethoxysilane; aminosilanes such as aminopropyltriethoxysilane, ureidopropyltriethoxysilane, and N-phenylaminopropyltrimethoxysilane; and hydrophobic silane compounds such as phenyltrimethoxysilane, methyltrimethoxysilane, octadecyltrimethoxysilane, and n-decyltrimethoxysilane.

Among them, a hydrophobic silane compound is more preferable. By using such a silane coupling agent C, the viscosity tends to further decrease, and a change in hardness tends to be further suppressed.

A content of the silane coupling agent C may be preferably 2.0% by mass or more, 5.0% by mass or more, 7.0% by mass or more, or 10.0% by mass or more based on the total amount of the matrix component. The content of the silane coupling agent C may be preferably 16.0% by mass or less, 12.0% by mass or less, 10.0% by mass or less, 5.0% by mass or less, or 3.0% by mass or less based on the total amount of the matrix component. When the content of the silane coupling agent C is within the above range, the viscosity tends to further decrease, and a change in hardness tends to be further suppressed.

### 1.2. Filler component

The filler component comprises: alumina D1; and magnesium oxide D2 and/or aluminum nitride D3, and may further include silica D4 or other fillers D5 as necessary.

A content of the filler component may be preferably 60% by volume or more, 65% by volume or more, 70% by volume or more, 75% by volume or more, 80% by volume or more, or 85% by volume or more based on a total amount of the thermal grease. The content of the filler component may be preferably 95% by volume or less or 90% by volume or less based on the total amount of the thermal grease. When the content of the filler component is within the above range, the thermal conductivity tends to be further improved, the viscosity tends to be further reduced, and a change in hardness tends to be further suppressed.

Each filler component may be surface-treated with a surface treatment agent by a known wet treatment method or dry treatment method. The surface treatment agent is not particularly limited, and examples thereof include the above-described silane coupling agent C, but the silane coupling agent C may be added regardless of the surface treatment.

### 1.2.1. Alumina D1

The average particle diameter of the alumina D1 is preferably 0.1 to 120 $\mu$m, and more preferably 0.1 to 90 $\mu$m. When an average particle diameter of the alumina D1 is within the above range, fluidity, dispersibility, and filling properties tend to be further improved. The average particle diameter in the present embodiment means D50 (median diameter).

A content of the alumina D1 may be preferably 40% by mass or more, 45% by mass or more, 55% by mass or more, 60% by mass or more, 65% by mass or more, or 70% by mass or more based on the total amount of the filler component. The content of the alumina D1 may be preferably 90% by mass or less, 85% by mass or less, 80% by mass or less, 75% by mass or less, or 70% by mass or less based on the total amount of the filler component. When the content of the alumina D1 is within the above range, the thermal conductivity tends to be further improved, the viscosity tends to be further reduced, and a change in hardness tends to be further suppressed.

In addition, as the alumina D1, fillers having different average particle diameters may be used by being mixed. For example, the alumina D1 may include any of the alumina D11 having an average particle diameter of 55 $\mu$m or more, alumina D12 having an average particle diameter of 10 $\mu$m or more and less than 55 $\mu$m, and alumina D13 having an average particle diameter of 0.10 μm or more and less than 10 μm, and these may be used in combination. When using such alumina D1, the thermal conductivity tends to be further improved, the viscosity tends to further decrease, and a change in hardness tends to be further suppressed.

1.2.1.1. Alumina D11

The alumina D1 preferably further includes alumina D11 having an average particle diameter of 55 μm or more. As a result, thermal conductivity tends to be further improved.

The average particle diameter of the alumina D11 is 55 μm or more, and preferably 60 μm or more, or 60 μm or more. An average particle diameter of the alumina D11 may be preferably 110 μm or less, 100 μm or less, 90 μm or less, or 80 μm or less. When the average particle diameter of the alumina D11 is within the above range, thermal conductivity tends to be further improved, the viscosity tends to further decrease, and a change in hardness tends to be further suppressed.

A content of the alumina D11 may be preferably 5% by mass or more, 10% by mass or more, or 15% by mass or more based on the total amount of the filler component. In addition, the content of the alumina D11 may be preferably 35% by mass or less, 30% by mass or less, or 25% by mass or less based on the total amount of the filler component. When the content of the alumina D11 is within the above range, the thermal conductivity tends to be further improved, the viscosity tends to further decrease, and a change in hardness tends to be further suppressed.

1.2.1.2. Alumina D12

The average particle diameter of the alumina D12 may be 10 μm or more, and preferably 15 μm or more, or 20 μm or more. The average particle diameter of the alumina D12 is less than 55 μm, and preferably 50 μm or less, 45 μm or less, 40 μm or less, 35 μm or less, or 30 μm or less. When the average particle diameter of the alumina D12 is within the above range, thermal conductivity tends to be further improved, the viscosity tends to further decrease, and a change in hardness tends to be further suppressed.

The content of the alumina D12 may be preferably 1.0% by mass or more, 2.5% by mass or more, or 5.0% by mass or more based on the total amount of the filler component. In addition, the content of the alumina D12 may be preferably 20% by mass or less, 15% by mass or less, or 10% by mass or less based on the total amount of the filler component. When the content of the alumina D12 is within the above range, the thermal conductivity tends to be further improved, the viscosity tends to further decrease, and a change in hardness tends to be further suppressed.

1.2.1.3. Alumina D13

The average particle diameter of the alumina D13 may be 0.10 μm or more, and preferably 0.20 μm or more, or 0.30 μm or more. The average particle diameter of the alumina D13 is less than 10 μm, and preferably may be 8.0 μm or less, 6.0 μm or less, or 5.0 μm or less. When the average particle diameter of the alumina D13 is within the above range, thermal conductivity tends to be further improved, the viscosity tends to further decrease, and a change in hardness tends to be further suppressed.

The content of the alumina D13 may be preferably 20% by mass or more, 25% by mass or more, 30% by mass or more, 35% by mass or more, or 40% by mass or more based on the total amount of the filler component. In addition, the content of the alumina D12 may be preferably 60% by mass or less, 55% by mass or less, 50% by mass or less, or 45% by mass or less based on the total amount of the filler component. When the content of the alumina D13 is within the above range, the thermal conductivity tends to be further improved, the viscosity tends to further decrease, and a change in hardness tends to be further suppressed.

1.2.2. Magnesium oxide D2 and/or aluminum nitride D3

The average particle diameter of the magnesium oxide D2 may be preferably 300 μm or less, 250 μm or less, 200 μm or less, 175 μm or less, 150 μm or less, or 125 μm or less. The average particle diameter of the magnesium oxide D2 and the aluminum nitride D3 may be preferably 25 μm or more, 50 μm or more, 70 μm or more, 80 μm or more, 90 μm or more, 100 μm or more, or 110 μm or more. When the average particle diameter of the magnesium oxide D2 is within the above range, the thermal conductivity tends to be further improved, the viscosity tends to further decrease, and a change in hardness tends to be further suppressed.

The average particle diameter of the aluminum nitride D3 may be preferably 300 μm or less, 250 μm or less, 200 μm or less, 175 μm or less, 150 μm or less, 125 μm or less, or 110 μm or less. The average particle diameter of the magnesium oxide D2 and the aluminum nitride D3 may be preferably 25 μm or more, 50 μm or more, 60 μm or more, 70 μm or more, 80 μm or more, or 90 μm or more. When the average particle diameter of the aluminum nitride D3 is within the above range, the thermal conductivity tends to be further improved, the viscosity tends to further decrease, and a change in hardness tends to be further suppressed.

The total content of the magnesium oxide D2 and the aluminum nitride D3 is 10% by mass or more, preferably 15% by mass or more, preferably 20% by mass or more, 25% by mass or more, 30% by mass or more, 35% by mass or more, 40% by mass or more, or 45% by mass or more based on the total amount of the filler component. The total content of the magnesium oxide D2 and the aluminum nitride D3 is 60% by mass or less, preferably 55% by mass or less, 50% by mass or less, or 45% by mass or less based on the total amount of the filler component. When the total content of the magnesium oxide D2 and the aluminum nitride D3 is within the above range, the thermal conductivity tends to be further improved, the viscosity tends to further decrease, and a change in hardness tends to be further suppressed.

### 1.2.3. Silica D4

The filler component may further include the silica D4. As a result, the viscosity tends to further decrease, and a change in hardness tends to be further suppressed.

A content of the silica D4 may be preferably 0.1% by mass or more, 1.0% by mass or more, 2.5% by mass or more, or 5.0% by mass or more based on the total amount of the heat dissipation filler. In addition, the content of the silica D4 may be preferably 15% by mass or less, 10% by mass or less, or 5.0% by mass or less based on the total amount of the heat dissipation filler. When the content of the silica D4 is within the above range, the thermal conductivity tends to be further improved, the viscosity tends to further decrease, and a change in hardness tends to be further suppressed.

### 1.2.4. Other fillers D5

The other fillers D5 are not particularly limited, and examples thereof include boron nitride, silicon nitride, zinc oxide, aluminum hydroxide, metallic aluminum, diamond, carbon, indium, gallium, copper, silver, iron, nickel, gold, tin, and metallic silicon.

Among them, it is preferable to contain at least one or more selected from the group consisting of boron nitride, silicon nitride, zinc oxide, aluminum hydroxide, metalic aluminum, copper, silver, and diamond. By using these fillers D5, the filling property tends to be improved, and the thermal conductivity of the thermal grease tends to be further improved. These fillers D5 may be used singly or in combination of two or more kinds thereof.

### 2. Electronic device

An electronic device according to the present embodiment includes a heating element, a heat sink, and the thermal grease, and the thermal grease is disposed between the heating element and the heat sink. In this electronic device, the heating element and the heat sink are thermally coupled via thermal grease.

Here, the heating element is not particularly limited, and examples thereof include a circuit board used for a motor, a battery pack, an in-vehicle power supply system, and an electronic component that generates heat, such as a power transistor and a microprocessor. Among them, an electronic component used in an in-vehicle power supply system for a vehicle is preferable. The heat sink is not particularly limited as long as it is a component configured for the purpose of heat dissipation or heat absorption.

A method for coupling the heating element and the heat sink via the thermal grease is not particularly limited. For example, an electronic device may be obtained by coupling a heating element and a heat sink using the thermal grease.

### Examples

Hereinafter, the present invention will be described more specifically using examples and comparative examples. The present invention is not limited at all by the following examples. Unless otherwise specified, each operation was performed at normal temperature (25°C).

### 1. Preparation of thermal grease (Examples 1 to 8 and Comparative Examples 1 to 4)

A thermal grease was prepared by mixing a silicone A, a surfactant B, a silane coupling agent C, and a filler D with the composition shown in Table 1. In Table 1, compositions of respective components are indicated so that total amounts of the matrix component and the filler component are 100 parts by mass, respectively. Also, a mixing ratio of the matrix component and the filler component is expressed as a total filling amount of the filler component. The following evaluation was performed using each obtained thermal grease. The results are shown in Table 1.

### 1.1. Raw materials

(Silicone A)

Low molecular silicone A1: "KF-96-50 CS" manufactured by Shin-Etsu Chemical Co., Ltd.
High molecular silicone A2: "SRH-32" manufactured by Momentive Performance Materials Inc.

(Surfactant B)

Surfactant B1 obtained in Preparation Example 1 below
Surfactant B2 obtained in Preparation Example 2 below

(Silane coupling agent C)

n-Decyltrimethoxysilane: "DOWSIL Z-6210 Silane", manufactured by Dow Toray Co., Ltd.

(Alumina D1)

Aluminum oxide: "DAW 120" manufactured by Denka Company Limited, average particle diameter: 120 $\mu$m
Aluminum oxide: "DAW 70" manufactured by Denka Company Limited, average particle diameter: 70 $\mu$m
Aluminum oxide: "DAW 20" manufactured by Denka Company Limited, average particle diameter: 20 $\mu$m
Aluminum oxide: "DAW05" manufactured by Denka Company Limited, average particle diameter: 5 $\mu$m
Aluminum oxide: "AA05" manufactured by Denka Company Limited, average particle diameter: 0.5 $\mu$m
Aluminum oxide: "ASFP 40" manufactured by Denka Company Limited, average particle diameter: 0.4 $\mu$m
Aluminum oxide: "ASFP 20" manufactured by Denka Company Limited, average particle diameter: 0.2 $\mu$m

(Magnesium Oxide D2)

Magnesium oxide: "DMG 120" manufactured by Denka Company Limited, particle diameter 120 $\mu$m

(Aluminum nitride D3)

Aluminum nitride: "AN-HF 100LG" manufactured by Combustion Synthesis Co., Ltd., particle diameter: 100 $\mu$m
Aluminum nitride: "AN-HF 80LG" manufactured by Combustion Synthesis Co., Ltd., particle diameter: 80 $\mu$m

(Silica D4)

Silica: "5X" manufactured by TATSUMORI LTD., average particle diameter 1.2 $\mu$m
The average particle diameter of each filler component was measured using a "laser diffraction particle size distribution analyzer SALD-20" manufactured by Shimadzu Corporation. For the evaluation sample, 50 ml of pure water and 5 g of each filler component to be measured were added to a glass beaker, stirred using a spatula, and then subjected to a dispersion treatment for 10 minutes using an ultrasonic cleaner. The dispersion of each filler component subjected to the dispersion treatment was added dropwise to a sampler section of a device using a dropper, and the measurement was performed when the absorbance was stabilized. As the average particle diameter, D50 (median diameter) was employed.

1.2. Preparation Example 1 (Surfactant B1)

In an autoclave with a stirrer, acrylic acid (manufactured by Toagosei Co., Ltd.) as a unit $\alpha$, 1,2,2,6,6-pentamethyl-4-piperidyl methacrylate ("ADK STAB LA-82" manufactured by ADEKA Corporation) as a unit $\beta$, and $\alpha$-butyl-$\omega$-(3-methacryloxypropyl)polydimethylsiloxane as a unit $\gamma$ ("Silaplane FM-0725" manufactured by JNC Corporation, number average molecular weight of 5,000) were added. Next, azobisisobutyronitrile (manufactured by Tokyo Chemical Industry Co., Ltd.) as an initiator and a mixed solution of toluene and 2-propanol as a solvent were added, and the autoclave was purged with nitrogen. Thereafter, the autoclave was heated at 65°C for 20 hours in an oil bath to perform radical polymerization. After completion of the polymerization, degassing was performed at 120°C for 1 hour under reduced pressure to obtain a surfactant B1.

A rate of polymerization based on the charged amount of the monomer of 100% was 98% or more as analyzed by gas chromatography analysis. From this, a proportion of each monomer unit of the surfactant B1 was estimated to be about the same as the charging ratio of the monomers. That is, the surfactant B1 was a copolymer containing a unit $\alpha$ of 48.4 mol%, a unit $\beta$ of 1.6 mol%, and a unit $\gamma$ of 50 mol%.

In addition, a weight average molecular weight of the obtained surfactant B1 was determined as a weight average molecular weight in terms of standard polystyrene using a gel permeation chromatography (GPC) method, and consequently the weight average molecular weight was 65,000. The measurement conditions are as follows.

High-speed GPC device: "HLC-8020" manufactured by Tosoh Corporation
Column: 1 column of "TSK guardcolumn MP ($\times$L)" manufactured by Tosoh Corporation, 6.0 mmID $\times$ 4.0 cm, and 2 columns of "TSK-GELMULTIPOREHXL-M" manufactured by Tosoh Corporation, 7.8 mmID $\times$ 30.0 cm (theoretical plate number of 16,000 stages), 3 columns in total (theoretical plate number of 32,000 stages as a whole)
Developing solvent: Tetrahydrofuran
Detector: RI (differential refractometer)

1.3. Preparation Example 2 (Surfactant B2)

In an autoclave with a stirrer, acrylic acid (manufactured by Toagosei Co., Ltd.) as a unit $\alpha$, 1,2,2,6,6-pentamethyl-4-piperidyl methacrylate ("ADK STAB LA-82" manufactured by ADEKA Corporation) as a unit $\beta$, and $\alpha$-butyl-$\omega$-(3-methacryloxypropyl)polydimethylsiloxane as a unit $\gamma$ ("Silaplane FM-0725" manufactured by JNC Corporation, number average molecular weight of 10,000) were added. Next, azobisisobutyronitrile (manufactured by Tokyo Chemical Industry Co., Ltd.) as an initiator and a mixed solution of toluene and 2-propanol as a solvent were added, and the autoclave was purged with nitrogen. Thereafter, the autoclave was heated at 65°C for 20 hours in an oil bath to perform radical polymerization. After completion of the polymerization, degassing was performed at 120°C for 1 hour under reduced pressure to obtain a surfactant B2.

A rate of polymerization based on the charged amount of the monomer of 100% was 98% or more as analyzed by gas chromatography analysis. From this, a proportion of each monomer unit of the surfactant B2 was estimated to be about the same as the charging ratio of the monomers. That is, the surfactant B2 was a copolymer containing a unit $\alpha$ of 67.7 mol%, a unit $\beta$ of 2.3 mol%, and a unit $\gamma$ of 30 mol%.

In addition, a weight average molecular weight of the obtained surfactant B2 was determined as a weight average molecular weight in terms of standard polystyrene using a gel permeation chromatography (GPC) method, and consequently the weight average molecular weight was 85,000. The measurement conditions were the same as in Preparation Example 1.

2. Evaluation

2.1. Cracking

Two 76 mm-square alkali-free glass plates were prepared, and thermal grease was applied to the central portion of one of the glass plates so as to have a diameter of 20 mm and a thickness of 1 mm, and a sandwiched sample in the other glass plate was held in an environment of 150°C. After holding for 24 hours, the presence or absence of cracks was visually confirmed.

2.2. Viscosity

In a rotary rheometer MARS III manufactured by Thermo Scientific, a parallel plate having a diameter of 35 mm was used as an upper jig, a thermal grease was placed on a lower plate having a diameter of 35 mm, the temperature of which can be controlled by a Peltier element, and the lower plate was compressed to a thickness of 1 mm by the upper jig, and a protruding portion was scraped and measured at 25°C. The viscosity was measured at a shear rate of 10 s$^{-1}$. When the viscosity is 1,000 Pa·s or lower, handling such as grease coatability is facilitated, which is suitable.

2.3. Thermal conductivity

The thermal resistance was measured between a rectangular parallelepiped copper jig having a heater embedded therein and having a tip of 100 mm$^2$ (10 mm $\times$ 10 mm) and a rectangular parallelepiped copper jig having a cooling fin attached thereto and having a tip of 100 mm$^2$ (10 mm $\times$ 10 mm) with a thermal grease interposed therebetween in a range where the thickness of the gap was 0.05 mm to 0.30 mm, and the thermal conductivity (W/m·k) was calculated from the thermal resistance and the gradient of the thickness and evaluated. The thermal resistance was calculated by the following equation by applying power of 10 W to the heater and holding the heater for 30 minutes, and measuring the temperature difference (°C) between the copper jigs.

$$\text{Thermal resistance } (°C/W) = \{\text{Temperature difference} (°C)/\text{Power } (W)\}$$

When the thermal conductivity is 8.0 W/m·K or more, heat dissipation is excellent and suitable.

2.4. Change in Asker C hardness

The Asker C hardness of the thermal grease was measured with "ASKER Durometer Type C" manufactured by Kobunshi Keiki Co., Ltd. Then, in Table 1, with the initial hardness measured immediately after adjusting the thermal grease as a reference (0), a value of the Asker C hardness when stored in an environment at 150°C for 0 to 500 hours for a predetermined time is measured, and a part thereof is shown below.

[Table 1]

| Matrix com-ponents | | | | EXAMPLE | | | | | | | | | |
|---|---|---|---|---|---|---|---|---|---|---|---|---|---|
| | | | | 1 | 2 | 3 | 4 | 5 | 6 | 7 | 8 | 9 | 10 |
| | Silicone A | Low molecular silicone A1 | part by weight | 58.80 | 58.80 | 58.80 | 54.08 | 78.40 | 54.23 | 53.86 | 53.67 | 53.59 | 78.40 |
| | | High molecular silicone A2 | part by weight | 1.20 | 1.20 | 1.20 | 5.95 | 1.60 | 5.97 | 5.92 | 5.90 | 5.89 | 1.60 |
| | Surfactant B | Surfactant B1 | part by weight | 12.00 | 12.00 | 12.00 | 25.49 | | 25.56 | 25.39 | 25.29 | 25.26 | 6.00 |
| | | Surfactant B2 | part by weight | 28.00 | 28.00 | 28.00 | | 20.00 | | | | | 14.00 |
| | Silane coupling agent C | | part by weight | | | | 14.48 | | 14.24 | 14.83 | 15.14 | 15.26 | |

| | | | EXAMPLE | | | | | | | | | |
|---|---|---|---|---|---|---|---|---|---|---|---|---|
| | | | 1 | 2 | 3 | 4 | 5 | 6 | 7 | 8 | 9 | 10 |
| Filler components | | Total filling amount | vol% | 86.30 | 86.30 | 86.30 | 86.30 | 86.30 | 86.30 | 87.00 | 87.00 | 87.00 | 86.30 |
| | Aluminum nitride | AN-HF100LG particle diameter of 100$\mu$m | part by weight | | 15.00 | 20.00 | 30.00 | 30.00 | 45.00 | | | | |
| | | AN-HF80LG particle diameter of 80 $\mu$m | part by weight | | | | | | | 52.00 | 52.00 | 52.00 | |
| | Magnesium oxide | DMG120 particle diameter of 120 $\mu$m | part by weight | 30.00 | 15.00 | 10.00 | | | | | | | 30.00 |
| | Alumina | DAW120 particle diameter of 120 $\mu$m | part by weight | | | | | | | | | | |
| | | DAW70 particle diameter of 70 $\mu$m | part by weight | 22.00 | 22.00 | 22.00 | 22.00 | 22.00 | 7.00 | | | | 22.00 |
| | | DAW20 particle diameter of 20 $\mu$m | part by weight | 7.00 | 7.00 | 7.00 | 7.00 | 7.00 | 7.00 | 10.00 | 10.00 | | 7.00 |
| | | DAW05 particle diameter of 5 $\mu$m | part by weight | 28.00 | 28.00 | 28.00 | 26.00 | 28.00 | 26.00 | 18.00 | 18.00 | 30.00 | 28.00 |
| | | AA05 particle diameter of 0.5 $\mu$m | part by weight | 13.00 | 13.00 | 13.00 | 10.00 | 13.00 | 10.00 | | | | 13.00 |
| | | ASFP40 particle diameter of 0.4 $\mu$m | part by weight | | | | | | | 10.00 | 15.00 | 15.00 | |
| | | ASFP20 particle diameter of 0.2 $\mu$m | part by weight | | | | 5.00 | | 5.00 | | | | |
| | Silica | 5X particle diameter of 1.2 $\mu$m | part by weight | | | | | | | 10.00 | 5.00 | 3.00 | |

(continued)

| Physical properties | | | | EXAMPLE | | | | | | | | | |
| --- | --- | --- | --- | --- | --- | --- | --- | --- | --- | --- | --- | --- | --- |
| | | | | 1 | 2 | 3 | 4 | 5 | 6 | 7 | 8 | 9 | 10 |
| | Cracking during compression | | | None | None | None | None | None | None | None | None | None | None |
| | Viscosity | $10S^{-1}$ | Pa·s | 600 | 500 | 500 | 250 | 450 | 240 | 450 | 420 | 400 | 500 |
| | Thermal conductivity | | W/m·k | 8.0 | 8.2 | 8.2 | 8.2 | 9.1 | 9.0 | 9.5 | 9.4 | 9.7 | 8.1 |
| | Change in Asker C hardness | 150hr | | 0 | 0 | 0 | 10 | 13 | 0 | 6 | 0 | 0 | 0 |
| | | 300hr | | 2 | 0 | 2 | 22 | 34 | <40 | <40 | 35※ | 10※ | 11 |

* It is a value of a change in hardness after 500 hours.

[Table 2]

|  |  |  |  | COMPARATIVE EXAMPLE | | | | | |
|---|---|---|---|---|---|---|---|---|---|
|  |  |  |  | 1 | 2 | 3 | 4 | 5 | 6 |
| Matrix components | Silicone A | Low molecular silicone A1 | part by weight | 68.60 | 69.43 | 58.80 | 58.80 | 58.80 | 58.80 |
|  |  | High molecular silicone A2 | part by weight | 1.40 | 7.63 | 1.20 | 1.20 | 1.20 | 1.20 |
|  | Surfactant B | Surfactant B1 | part by weight | 6.00 | 8.48 | 0.00 | 0.00 | 0.00 | 0.00 |
|  |  | Surfactant B2 | part by weight | 24.00 |  | 40.00 | 40.00 | 40.00 | 40.00 |
|  | Silane coupling agent C | | part by weight |  | 14.46 |  |  |  |  |
| Filler components | Total filling amount | | vol% | 86.30 | 86.30 | 86.30 | 87.00 | 86.30 | 86.50 |
|  | Aluminum nitride | AN-HF100LG particle diameter of 100$\mu$m | part by weight |  | 30.00 |  |  |  |  |
|  |  | AN-HF80LG particle diameter of 80 $\mu$m | part by weight |  |  |  |  |  |  |
|  | Magnesium oxide | DMG120 particle diameter of 120 $\mu$m | part by weight |  |  |  |  |  |  |
|  | Alumina | DAW120 particle diameter of 120 $\mu$m | part by weight | 30.00 |  |  |  |  |  |
|  |  | DAW70 particle diameter of 70 $\mu$m | part by weight | 22.00 | 22.00 | 50.00 | 50.00 | 58.00 | 58.00 |
|  |  | DAW20 particle diameter of 20 $\mu$m | part by weight | 7.00 | 7.00 | 11.00 | 11.00 | 3.00 | 12.00 |
|  |  | DAW05 particle diameter of 5 $\mu$m | part by weight | 28.00 | 26.00 | 24.00 | 24.00 | 24.00 | 15.00 |
|  |  | AA05 particle diameter of 0.5 $\mu$m | part by weight | 13.00 | 10.00 | 15.00 | 15.00 | 15.00 | 15.00 |
|  |  | ASFP40 particle diameter of 0.4 $\mu$m | part by weight |  |  |  |  |  |  |
|  |  | ASFP20 particle diameter of 0.2 $\mu$m | part by weight |  | 5.00 |  |  |  |  |
|  | Silica | 5X particle diameter of 1.2 $\mu$m | part by weight |  |  |  |  |  |  |

(continued)

| | | | | COMPARATIVE EXAMPLE | | | | | |
| | | | | 1 | 2 | 3 | 4 | 5 | 6 |
|---|---|---|---|---|---|---|---|---|---|
| Physical properties | Cracking during compression | | | None | None | - | - | - | - |
| | Viscosity | $10S^{-1}$ | Pa·s | 450 | 200 | - | - | - | - |
| | Thermal conductivity | | W/m·k | 8.1 | 8.2 | 7.5 | 7.6 | 7.3 | 6.9 |
| | Change in Asker C hardness | 150hr | | 21 | 0 | - | - | - | - |
| | | 300hr | | 84 | 50 | - | - | - | - |

-: Since the thermal conductivity is less than 8.0 W/m·K and does not reach a target value, no other evaluation is made.

Industrial Applicability

The thermal grease of the present invention has industrial applicability as thermal grease or the like for thermally connecting a heating element and a heat sink in an electronic device.

**Claims**

1. A thermal grease comprising:

   a matrix component; and a filler component,
   wherein the matrix component comprises a silicone A and a surfactant B,
   the filler component comprises:

   alumina D1; and
   magnesium oxide D2 and/or aluminum nitride D3,

   a content of the surfactant B may be 15% by mass or more based on a total amount of the matrix component, and
   a total content of the magnesium oxide D2 and the aluminum nitride D3 is 10% to 60% by mass based on a total amount of the filler component.

2. The thermal grease according to claim 1,
   wherein a content of the filler component is 60% to 95% by volume based on a total amount of the thermal grease.

3. The thermal grease according to claim 1,

   wherein an average particle diameter of the magnesium oxide D2 is 25 to 300 $\mu$m, and
   an average particle diameter of the aluminum nitride D3 is 25 to 300 $\mu$m.

4. The thermal grease according to claim 1,
   wherein the alumina D1 further comprises alumina D11 having an average particle diameter of 55 $\mu$m or more.

5. The thermal grease according to claim 1,
   wherein the silicone A comprises:

   a low molecular silicone A1 having a weight average molecular weight of 500 or more and 100,000 or less; and
   a high molecular silicone A2 having a weight average molecular weight of 150,000 or more and 1,000,000 or less.

6. The thermal grease according to claim 1,
   wherein a content of the low molecular silicone A1 is 50% to 80% by mass based on a total amount of the matrix component.

7. The thermal grease according to claim 1,
   wherein a content of the high molecular silicone A2 is 3.0% to 25% by mass based on a total amount of the matrix component.

8. The thermal grease according to claim 1,
   wherein a content of the surfactant B is 15% to 55% by mass based on a total amount of the matrix component.

9. The thermal grease according to claim 1,
   wherein the surfactant B comprises:

   a surfactant B1 having a silicone (meth)acrylic monomer unit $\gamma1$ having a weight average molecular weight of 1,000 or more and less than 8,000; and/or
   a surfactant B2 having a silicone (meth)acrylic monomer unit $\gamma2$ having a weight average molecular weight of 8,000 or more and 50,000 or less.

10. The thermal grease according to claim 1,
    wherein the matrix component further comprises a silane coupling agent C.

11. The thermal grease according to claim 10,
    wherein a content of the silane coupling agent C is 2.0% to 16.0% by mass based on a total amount of the matrix component.

12. The thermal grease according to claim 1,

    wherein the filler component further comprises silica D4, and
    a content of the silica D4 is 0.1% to 10% by mass based on a total amount of the filler component.

# EP 4 579 731 A1

## INTERNATIONAL SEARCH REPORT

| | International application No. |
|---|---|
| | **PCT/JP2023/026970** |

### A. CLASSIFICATION OF SUBJECT MATTER

*H01L 23/36*(2006.01)i; *H01L 23/373*(2006.01)i
FI:    H01L23/36 M; H01L23/36 D

According to International Patent Classification (IPC) or to both national classification and IPC

### B. FIELDS SEARCHED

Minimum documentation searched (classification system followed by classification symbols)

H01L23/36; H01L23/373

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| Y | WO 2020/209263 A1 (DENKA CO., LTD.) 15 October 2020 (2020-10-15) paragraphs [0013]-[0059] | 1-8, 10-12 |
| A | | 9 |
| Y | JP 2020-59842 A (TOYOTA MOTOR CORP.) 16 April 2020 (2020-04-16) paragraphs [0011]-[0034] | 1-4, 8, 10, 11 |
| A | | 9 |
| Y | JP 2016-216523 A (DENKA CO., LTD.) 22 December 2016 (2016-12-22) paragraphs [0013]-[0031] | 5-7, 12 |
| A | | 9 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **14 September 2023** | **26 September 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**
Information on patent family members

International application No.

**PCT/JP2023/026970**

| Patent document cited in search report | | | Publication date (day/month/year) | Patent family member(s) | | | Publication date (day/month/year) |
|---|---|---|---|---|---|---|---|
| WO | 2020/209263 | A1 | 15 October 2020 | US 2022/0186089 A1 paragraphs [0039]-[0085] EP 3954719 A1 CN 113677717 A KR 10-2021-0154977 A TW 202043306 A | | | |
| JP | 2020-59842 | A | 16 April 2020 | (Family: none) | | | |
| JP | 2016-216523 | A | 22 December 2016 | (Family: none) | | | |

Form PCT/ISA/210 (patent family annex) (January 2015)

22

**REFERENCES CITED IN THE DESCRIPTION**

**Patent documents cited in the description**

- JP 2018062552 A